# EUROPEAN PATENT SPECIFICATION

(11) **EP 3 414 837 B1**
(45) Date of publication and mention of the grant of the patent: **03.06.2020**
(21) Application number: 17762518.3
(22) Date of filing: 07.03.2017
(51) Int. Cl.: H03H 7/40, H04B 1/04, H04B 1/18

(54) **APPARATUS AND METHOD FOR IMPEDANCE MEASUREMENT AND ADAPTIVE ANTENNA TUNING**
VORRICHTUNG UND VERFAHREN ZUR IMPEDANZMESSUNG UND ADAPTIVEN ANTENNENABSTIMMUNG
APPAREIL ET PROCÉDÉ DE MESURE D'IMPÉDANCE ET DE SYNTONISATION ADAPTATIVE D'ANTENNE

(30) Priority: 09.03.2016 US 201615065313
(43) Date of publication of application: 19.12.2018
(73) Proprietor: Huawei Technologies Co., Ltd., Longgang District Shenzhen, Guangdong 518129 (CN)
(72) Inventor: SHI, Ping, San Diego, California 92129 (US)
(74) Representative: Gill Jennings & Every LLP
(86) International application number: PCT/CN2017/075894
(87) International publication number: WO 2017/152832

(56) References cited:
- US-A1- 2007 035 356
- US-A1- 2009 046 030
- US-A1- 2011 285 603
- US-A1- 2012 041 699
- US-A1- 2012 119 971
- US-A1- 2014 120 849
- US-A1- 2014 167 878

## Description

### TECHNICAL FIELD

The present invention relates to antenna design for wireless communications, and, in particular embodiments, to an apparatus and method for impedance measurement and adaptive antenna tuning.

### BACKGROUND

Impedance tuning generally improves antenna performance by adjusting an impedance matching element coupled to a feed line of an antenna based on a reflection coefficient of the antenna circuit. The reflection coefficient may vary over time based on, for example, the presence of human tissue and/or conductive (e.g., metallic) objects in close proximity to the antenna. Accordingly, many modern wireless devices perform adaptive impedance tuning by monitoring the antenna's reflection coefficient during wireless transmission, and adjusting the impedance matching element accordingly. Conventional approaches for monitoring an antenna's reflection coefficient typically encompass measuring both the magnitude and phase components of the incident and reflected signals, which can then be used to compute the magnitude and phase components of the reflection coefficient.
US20070035356 describes that an impedance matching system may be used, for example, for impedance matching between a transmitter/receiver front-end and an antenna in a mobile communication device. In a tuneable impedance matching system according to the invention a tuneable impedance matching circuit is used also as a measuring circuit for obtaining a value of a load impedance. A real part and an imaginary part of a load impedance is calculated based on voltages measured on nodes of the tuneable impedance matching circuit and on known component values of the tuneable impedance matching circuit. Values for adjustable electrical components of the tuneable impedance matching circuit are determined based on the obtained load impedance value and on an impedance matching condition.

US20110285603 describes an antenna interface circuit for a wireless communication device which includes a tunable matching circuit that is coupleable to an antenna. The tunable matching circuit includes a variable impedance element having a variable impedance Ztune. The interface circuit further includes a fixed impedance element having a fixed impedance Zmeas, and a switch coupled to the fixed impedance element and configured to controllably switch the fixed impedance element into electrical communication with the tunable matching circuit.

US20140120849 describes circuitry integrated into a silicon chip that measures aspects of an RF signal on a transmission line in order to provide data that is ultimately used by an antenna tuner circuit to substantially match the impedance of the antenna with that of the transmission line providing the RF frequency to be transmitted.

### SUMMARY OF THE INVENTION

Technical advantages are generally achieved, by embodiments of this disclosure which describe an apparatus and method for impedance measurement and adaptive antenna tuning.

In accordance with an embodiment, a method for matching the impedance of an antenna is provided according to appended claim 1.

In accordance with another embodiment, a wireless transceiver is provided according to appended claim 9.

### BRIEF DESCRIPTION OF THE DRAWINGS

For a more complete understanding of embodiments provided herein, and the advantages thereof, reference is now made to the following descriptions taken in conjunction with the accompanying drawing, in which:
FIG. 1 illustrates a diagram of an embodiment wireless communications network;
FIG. 2 illustrates a diagram of an embodiment antenna circuit for estimating a phase component of a reflection coefficient based on return loss measurements;
FIG. 3 illustrates a diagram of another embodiment antenna circuit for estimating a phase component of a reflection coefficient based on return loss measurements;
FIG. 4 illustrates a diagram of a yet another embodiment antenna circuit for estimating a phase component of a reflection coefficient based on return loss measurements;
FIG. 5 illustrates charts describing how a phase component of a reflection coefficient can be estimated based on return loss measurements;
FIG. 6 illustrates a flowchart of an embodiment method for estimating a phase component of a reflection coefficient based on return loss measurements;
FIG. 7 illustrates a diagram of a yet another embodiment antenna circuit for estimating a phase component of a reflection coefficient based on return loss measurements;
FIG. 8 illustrates charts describing how a phase component of a reflection coefficient can be estimated based on return loss measurements;
FIG. 9 illustrates a flowchart of another embodiment method for estimating a phase component of a reflection coefficient based on return loss measurements;
FIG. 10 illustrates diagrams of embodiment tunable matching circuits;
FIG. 11 illustrates diagrams of additional embodiment tunable matching circuits;
FIG. 12 illustrates diagrams of embodiment power detection circuits;
FIG. 13 illustrates diagrams of additional embodiment power detection circuits;
FIG. 14 illustrates a diagram of an embodiment processing system; and
FIG. 15 illustrates a diagram of an embodiment transceiver.

Corresponding numerals and symbols in the different figures generally refer to corresponding parts unless otherwise indicated. The figures are drawn to clearly illustrate the relevant aspects of the embodiments and are not necessarily drawn to scale.

### DETAILED DESCRIPTION OF ILLUSTRATIVE EMBODIMENTS

The making and using of embodiments of this disclosure are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

As mentioned above, conventional approaches for monitoring an antenna's reflection coefficient typically measure both the magnitude and phase components of the incident and reflected signals. This may generally require conventional transceivers to include both a power detection circuit and a phase detection circuit coupled to the antenna of the transceiver. Modern wireless devices are generally equipped with power detection circuits irrespective of whether they perform impedance matching, as transmit power control functionality is generally required to comply with Federal Communications Commission (FCC) regulations as well as for interference mitigation and management. However, many modern wireless devices do not directly monitor the phase of signals propagating over the antenna circuit for reasons other than impedance matching.

Aspects of this disclosure provide impedance matching techniques that estimate the phase component of a reflection coefficient based on return loss measurements without directly measuring the phase component of the reflection coefficient. This may allow wireless transceivers to achieve adaptive impeding matching without relying on a phase detection circuit coupled to the antenna, thereby reducing the cost and complexity of wireless transceivers. In particular, a transceiver may include a tunable matching circuit that includes one or more tunable elements and power detector coupled to an antenna through a directional coupler. In one embodiment, the transceiver measures an initial return loss of the antenna, adjusts the impedance of at least one tunable element, and then measures one or more adjusted return losses of the antenna. The phase of the reflection coefficient can be estimated based on a difference between the initial return loss and the one or more adjusted return losses. As used herein, the phrase estimating a phase of a reflection coefficient without directly measuring the phase of the reflection coefficient conveys that the phase of the reflection coefficient is obtained without using measured phase components of an incident signal and a reflected signal propagating over the antenna circuit. The phase of a received, or transmitted signal, may be measured by the transceiver for some other purpose. These and other aspects are discussed in greater detail below.

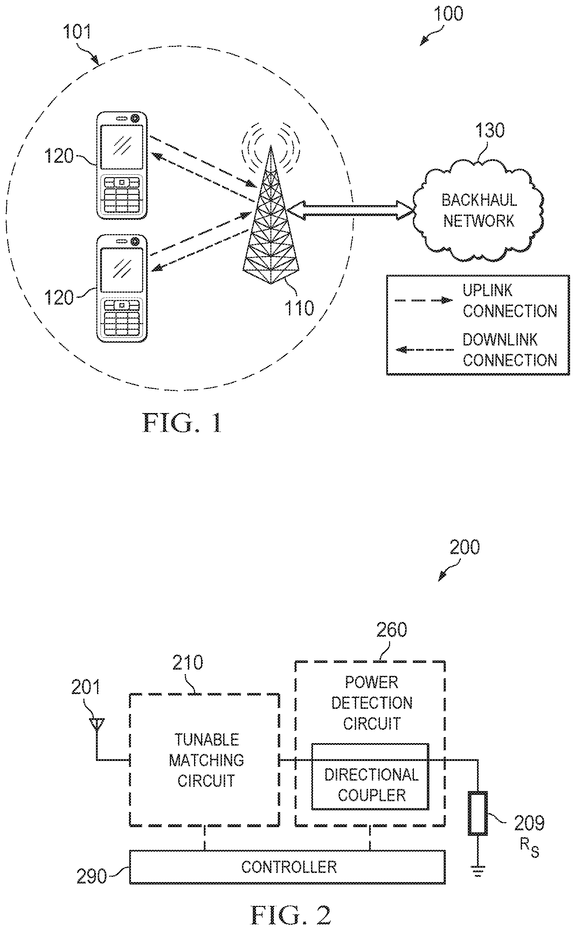

FIG. 1 illustrates a network 100 for communicating data. The network 100 comprises a base station 110 having a coverage area 101, a plurality of mobile devices 120, and a backhaul network 130. As shown, the base station 110 establishes uplink (dashed line) and/or downlink (dotted line) connections with the mobile devices 120, which serve to carry data from the mobile devices 120 to the base station 110 and vice-versa. Data carried over the uplink/downlink connections may include data communicated between the mobile devices 120, as well as data communicated to/from a remote-end (not shown) by way of the backhaul network 130. As used herein, the term "base station" refers to any component (or collection of components) configured to provide wireless access to a network, such as an enhanced base station (eNB), a macro-cell, a femtocell, a Wi-Fi access point (AP), or other wirelessly enabled devices. Base stations may provide wireless access in accordance with one or more wireless communication protocols, e.g., long term evolution (LTE), LTE advanced (LTE-A), High Speed Packet Access (HSPA), Wi-Fi 802.11a/b/g/n/ac, etc. As used herein, the term "mobile device" refers to any component (or collection of components) capable of establishing a wireless connection with a base station, such as a user equipment (UE), a mobile station (STA), and other wirelessly enabled devices. In some embodiments, the network 100 may comprise various other wireless devices, such as relays, low power nodes, etc.

Aspects of this disclosure provide impedance matching techniques that estimate the phase component of a reflection coefficient based on return loss measurements without directly measuring the phase component of the reflection coefficient. FIG. 2 illustrates a diagram of an embodiment antenna circuit 200 for estimating the phase component of an antenna reflection coefficient. As shown, the embodiment antenna circuit 200 includes an antenna 201, a source 209, a tunable matching circuit 210, a power detection circuit 260, and a controller 290. The antenna 201 may include any component, or collection of components, configured to emit or receive wireless signals. The source 209 may correspond to an impedance of transceiver circuitry (e.g., a duplexer, power amplifiers, low noise amplifiers, baseband processors, etc.) coupled to the antenna circuit 200. The tunable matching circuit 210 may include one or more tunable elements. The one or more tunable elements in the tunable matching circuit 210 may include any circuit element whose impedance can be adjusted, such as a tunable capacitor and/or a tunable inductor. The one or more tunable elements in the tunable matching circuit 210 may be arranged in various orientations with respect to the antenna 201, including shunt and/or series orientations. Embodiment configurations for the tunable matching circuit 210 are described in greater detail below.

The embodiment power detection circuit 260 may include any component, or collection of components, configured to measure the power of a signal propagating over the antenna circuit 200, such as a voltage or current detector. In some embodiments, the power detection circuit 260 is configured to measure a return loss of the antenna circuit 200 by measuring a voltage or power of an incident signal traveling from the source 209 to the antenna 201 and a reflected signal traveling from the antenna 200 to the source 209.

The controller 290 may be any component, or collection of components, configured to control the tunable matching circuit 210, control and receive measurement data from power detection circuit 260. By way of example, the controller 290 may include processors, digital-to-analog converters (DACs), gate drivers, and/or other components configured to vary an impedance of one or more tunable elements in the tunable matching circuit 210 and/or trigger the power detection circuit 260 to take a power measurement. The controller 290 may also be configured to estimate a phase component of a reflection coefficient of the antenna 201 based on the power measurements of the power detection circuit 260. In some embodiments, the phase component computations are performed offline, and stored in a look up table. In such embodiments, the controller 290 searches the look up table to determine a phase component value based on the power measurements. By way of example, the controller 290 may determine a phase component value associated an initial reflection coefficient and one or more adjusted reflection coefficients. In other embodiments, the phase component computations are performed online by the controller 290. Details for performing the phase component computations are discussed in greater detail below. The controller 290 may further be configured to adjust an impedance matching element of the antenna based on the magnitude and phase of the reflection coefficient.

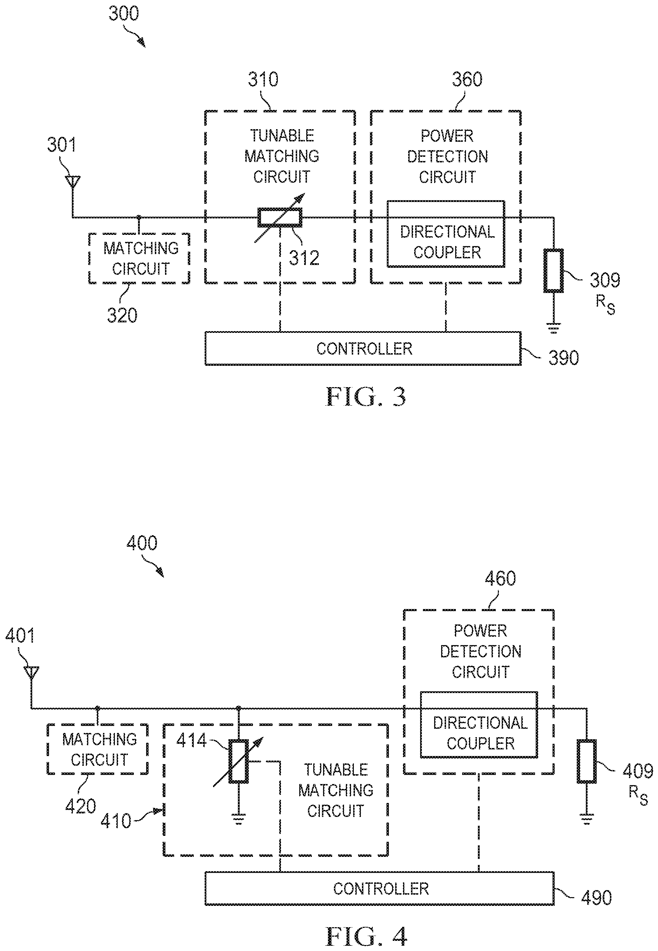

In some embodiments, a tunable matching circuit includes a series tunable element. FIG. 3 illustrates a diagram of an embodiment antenna circuit 300 for estimating the phase component of an antenna reflection coefficient. As shown, the embodiment antenna circuit 300 includes an antenna 301, a source 309, a tunable matching circuit 310 including of a serial tunable component, a matching circuit 320, a power detection circuit 360, and a controller 390, each of which may be configured similarly to like components of the embodiment antenna circuit 200. In this example, the tunable matching circuit 310 includes a series tunable element 312 coupled to the antenna 301 other matching circuit. The series tunable element 312 may include a tunable capacitor, a tunable inductor, or a combination thereof. The controller 390 may be configured to trigger the power detection circuit 360 to measure an initial return loss, to adjust an impedance of the series tunable element 312, and then to trigger the power detection circuit 360 to measure an adjusted return loss. The controller 390 may then estimate a phase component of a reflection coefficient for the antenna 301 based on the initial return loss, the adjusted return loss, and a range of phase components associated with the antenna circuit 300. which could be determined based on antenna characteristic and matching circuit configuration

In some embodiments, a tunable matching circuit includes a shunt tunable element. FIG. 4 illustrates a diagram of an embodiment antenna circuit 400 for estimating the phase component of an antenna reflection coefficient. As shown, the embodiment antenna circuit 400 includes an antenna 401, a source 409, a tunable matching circuit 410, a matching circuit 420, a power detection circuit 460, and a controller 490, each of which may be configured similarly to like components of the embodiment antenna circuit 200. In this example, the tunable matching circuit 410 includes a shunt tunable element 414 coupled to the antenna 401. The shunt tunable element 414 may include a tunable capacitor, a tunable inductor, or a combination thereof. The controller 490 may trigger the power detection circuit 460 to measure an initial return loss, adjust an impedance of the shunt tunable element 414, and trigger the power detection circuit 460 to measure an adjusted return loss. The controller 490 may then estimate a phase component of a reflection coefficient for the antenna 401 based on the initial return loss, the adjusted return loss, and a range of phase components associated with the reflection coefficient of antenna circuit 400.

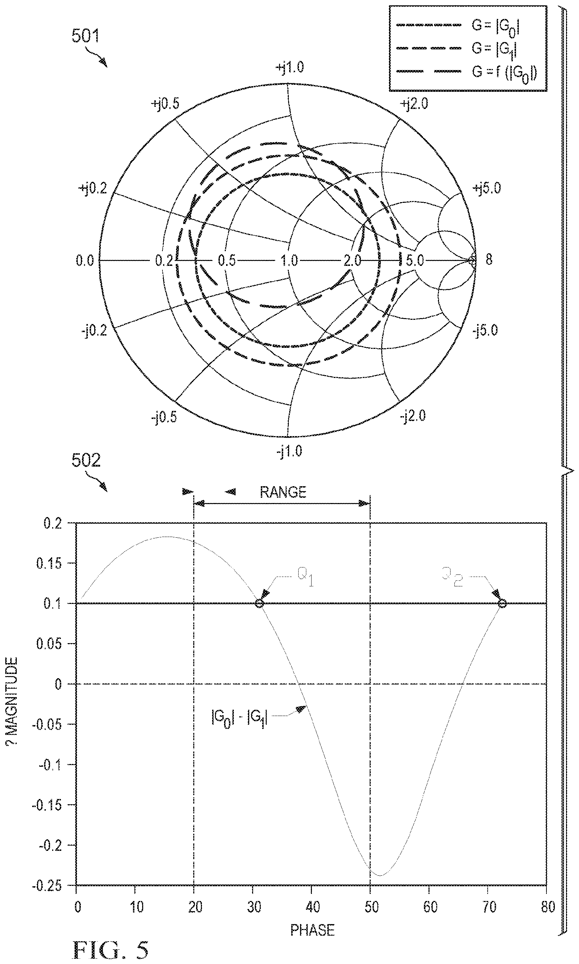

Embodiments provided herein may be used to estimate a phase component of a reflection coefficient based on an initial return loss measurement and an adjusted return loss measurement when the range of phase components for the reflection coefficient of an antenna is known. FIG. 5 illustrates a smith chart 501 and a graph 502 that describe how a phase component of a reflection coefficient can be estimated based on return loss measurements. The Smith chart 501 depicts a first circle (Γ = |Γ₀|) representing the complex reflection coefficient over all possible phases of an initial reflection coefficient (Γ₀) of the antenna with a matching network, and a second circle (Γ = f(Γ₀)) representing the complex reflection coefficient (Γ) over all phase of reflection coefficients after adjusting the tunable impedance. The first circle (Γ = |Γ₀|) is determined after the first return loss measurement with value corresponding to |Γ₀|. A third circle Γ = |Γ₁| is determined after a second return loss measurement with value corresponding to |Γ₁|. This third circle will intercept with the second circle at two points. The graph 502 illustrates the difference between the initial return loss measurement (|Γ₀|) and the adjusted return loss (|Γ|) as a function of the phase of the antenna initial reflection coefficient. When only a single adjusted return loss measurement is taken (as Γ = |Γ₁|), there are two potential values for the phase component of the reflection coefficient, namely Θ₁ and Θ₂, which correspond to the intercept points of the straight line y = |Γ₁|-|Γ₀| with the curve. In this case, it is known that the phase component of the reflection coefficient has a range between one-hundred and two-hundred and fifty degrees. Accordingly, Θ₁ is the estimated phase coefficient for the reflection coefficient of the antenna circuit.

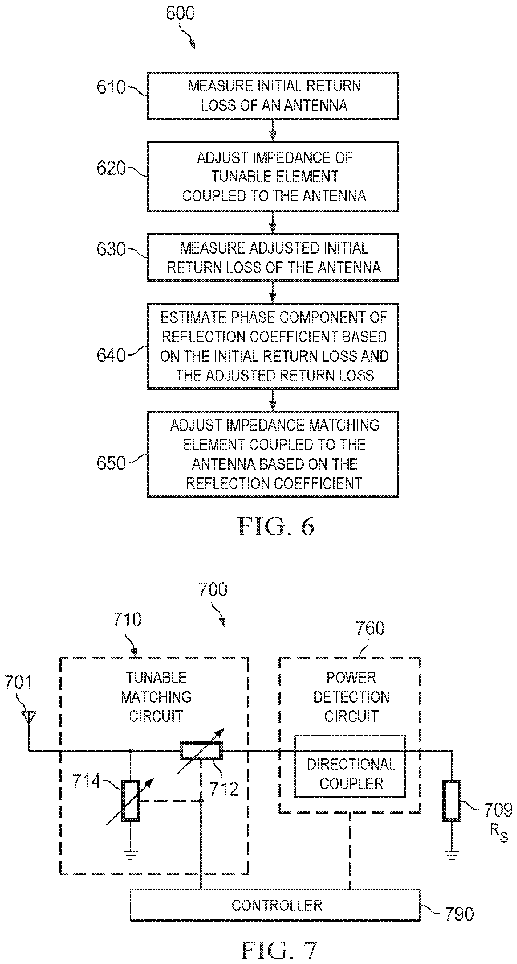

FIG. 6 illustrates a flowchart of an embodiment method 600 for estimating a phase component of a reflection coefficient based on return loss measurements, as may be performed by a controller. At step 610, the controller measures a return loss of an antenna with a matching network. This may be achieved by measuring the return loss at the directional coupler. This may include measuring a magnitude (e.g., a voltage or power) of an incident signal and a reflected signal, and then computing the return loss as the ratio between the magnitude of the incident signal and the magnitude of the return signal. At step 620, the controller adjusts the impedance of a tunable element coupled to the antenna. In one embodiment, this includes adjusting the capacitance of a tunable capacitor coupled to the antenna. In another embodiment, this includes adjusting the inductance of a tunable inductor coupled to the antenna. In some embodiments, multiple tunable elements are adjusted during step 620.

At step 630, the controller measures an adjusted return loss of the antenna with a matching network. The adjusted return loss measurement is taken after the impedance of the tunable element is adjusted in step 620. At step 640, the controller estimates the phase component of reflection coefficient based on the initial return loss and the adjusted return loss. This may be achieved by performing real time computation or by referring to a look up table that associates the return loss measurements with a phase value that was computed at initialization or retrieved from memory. With the complex reflection coefficient measured at a directional coupler, the antenna impedance (or reflection coefficient at the antenna feed plane) may be obtained by de-embedding the matching network from the antenna. This could be assisted with the knowledge of matching network between antenna and the power detector. At step 650, the controller adjusts an impedance matching element coupled to the antenna based on the reflection coefficient. The impedance matching element and the tunable element may include the same or different components.

Embodiments provided herein may utilize an initial return loss measurement and multiple adjusted return loss measurements to estimate a phase component of a reflection coefficient. This may be useful when the range of phase components for the antenna circuit is unknown. FIG. 7 illustrates a diagram of an embodiment antenna circuit 700 for estimating the phase component of an antenna reflection coefficient. As shown, the embodiment antenna circuit 700 includes an antenna 701, a source 709, a tunable matching circuit 710, a power detection circuit 760, and a controller 790, each of which may be configured similarly to like components of the embodiment antenna circuit 200. The embodiment antenna circuit 700 may optionally include an additional matching circuit between the tunable matching circuit 710 and the antenna 701. In this example, the controller 790 may be configured to estimate a phase component of a reflection coefficient of the antenna 701 based on the power measurements of the power detection circuit 760. In particular, the controller 790 may trigger the power detection circuit 760 to measure an initial return loss. The controller 790 may then adjust an impedance of one or both of a series tunable element 712 and a shunt tunable element 712 in the tunable matching circuit 710, and trigger the power detection circuit 760 to measure a first adjusted return loss. Thereafter, the controller 790 may re-adjust an impedance of one or both of the series tunable element 712 and the shunt tunable element 712, and trigger the power detection circuit 760 to measure a second adjusted return loss. Finally, the controller 790 may estimate a phase component of a reflection coefficient for the antenna 701 based on the initial return loss, the first adjusted return loss, and the second adjusted return loss. The controller 790 may estimate the phase component based on the three return loss measurements without knowing the range of phase components associated with the antenna circuit 700.

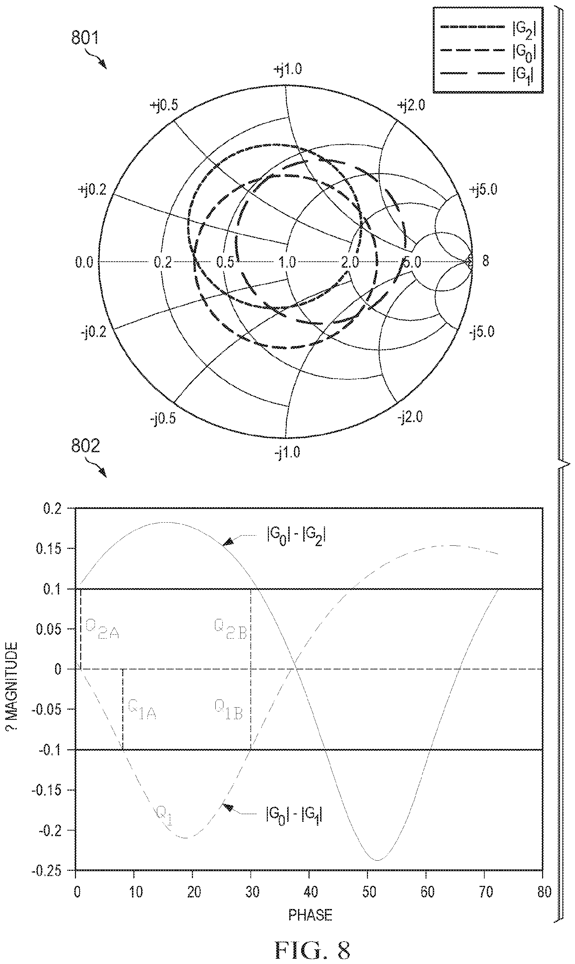

FIG. 8 illustrates a Smith chart 801 and a graph 802 that describe how a phase component of a reflection coefficient can be estimated based on return loss measurements. The Smith chart 801 depicts a first circle (Γ = |Γ₀|) representing the complex reflection coefficient (Γ) over all possible phases of an initial reflection coefficient (Γ₀) of the antenna with matching network. The Smith chart 801 further illustrates a second circle (Γ = f₁(Γ₀)) representing the complex reflection coefficient (Γ) over all phases of a first adjusted reflection coefficient, and a third circle (Γ = f₂(Γ)) representing the complex reflection coefficient (Γ) over all phases of a second adjusted reflection coefficient. The first circle (Γ = |Γ₀|) may represent complex values for the reflection coefficient (Γ) as a function of the initial return loss measurement (|Γ₀|). The second circle (Γ = f₁(Γ₀)) may represent complex values of the first adjusted reflection coefficient (Γ₁) after the first impedance adjustment, and the third circle (Γ = f₂(Γ₀)) may represent complex values of the second adjusted reflection coefficient (Γ₂) after the second impedance adjustment. The graph 802 illustrates the difference between the initial return loss measurement (|Γ₀|) and the first adjusted return loss (|Γ₁|), and the difference between the initial return loss measurement (|Γ₀|) and the second adjusted return loss (|Γ₂|) as a function of the phase of initial reflection coefficient of antenna. Two possible phases (Θ_{1A} and Θ_{1B}) of the initial reflection coefficient may be derived from a first adjusted return loss measurement. Two possible phases (Θ_{2A} and Θ_{2B}) of the initial reflection coefficient may also be derived from second adjusted return loss measurement. The correct phase component of the initial reflection coefficient (Γ₀) may be the common value derived from two measurements Θ_{1B}, as in this case.

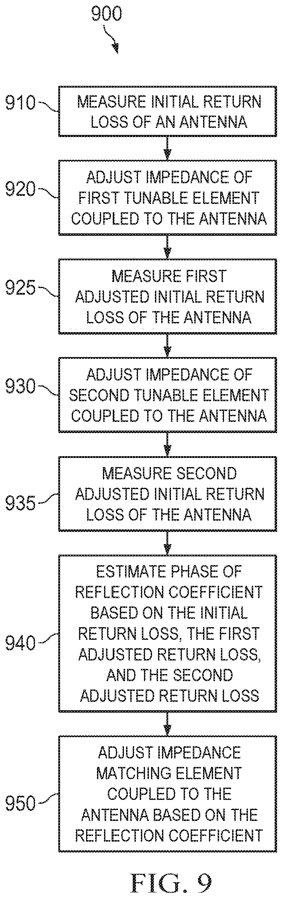

FIG. 9 illustrates a flowchart of an embodiment method 900 for estimating a phase component of a reflection coefficient based on return loss measurements, as may be performed by a controller. At step 910, the controller measures a return loss of an antenna with a matching network, as may be achieved by measuring the return loss at a directional coupler. This step may also include determining a ratio between a magnitude of an incident signal and a magnitude of a return signal. At step 920, the controller adjusts the impedance of one or more tunable elements coupled to the antenna. The tunable elements may include tunable capacitors and/or tunable inductors. At step 925, the controller measures a first adjusted return loss of the antenna. The first adjusted return loss measurement is taken after the impedance of the tunable element is adjusted in step 920. At step 930, the controller adjusts the impedance of one or more tunable elements coupled to the antenna. The tunable elements adjusted during step 930 may include one or more of the tunable elements adjusted during step 920. Alternatively, the tunable elements adjusted during step 930 may include different tunable elements than those adjusted during step 920. At step 935, the controller measures a second adjusted return loss of the antenna. The second adjusted return loss measurement is taken after the impedance of the tunable element is adjusted in step 930. At step 940, the controller estimates the phase component of reflection coefficient based on the initial return loss, the first adjusted return loss, and the second adjusted return loss. This may be achieved by performing an online computation or by referring to a look up table that associates the return loss measurements with a phase value that was computed offline. This will determine the complex reflection coefficient at directional coupler. With the complex reflection coefficient at directional coupler, the antenna impedance (or reflection coefficient at antenna feed) may be obtained by de-embedding the matching network between the power detector and the antenna. De-embedding the matching circuit may include obtaining the raw antenna impedance from the matched antenna impedance. In an embodiment, each component in the matching circuit may be treated as a two-port network element represented by a matrix (e.g., an ABCD-matrix), and the overall matching circuit is represented by another matrix, which is obtained by combining the matric associated with each element two-port network using a series-series, parallel-parallel, series-parallel, parallel-series, or cascade connection. In such an embodiment, de-embedding the matching circuit may include extracting raw antenna scattering parameters (e.g., S-parameters), which are related to the reflection coefficient, from the matched antenna scattering parameters and ABCD-matrix of matching network. This could be assisted with the knowledge of matching network between antenna and the power detector. At step 950, the controller adjusts one or more impedance matching elements coupled to the antenna based on the reflection coefficient. The impedance matching elements adjusted during step 950 may include one or more of the tunable elements adjusted during steps 920, 930. Alternatively, the impedance matching elements adjusted during step 950 may be different than the tunable elements adjusted during steps 920, 930.

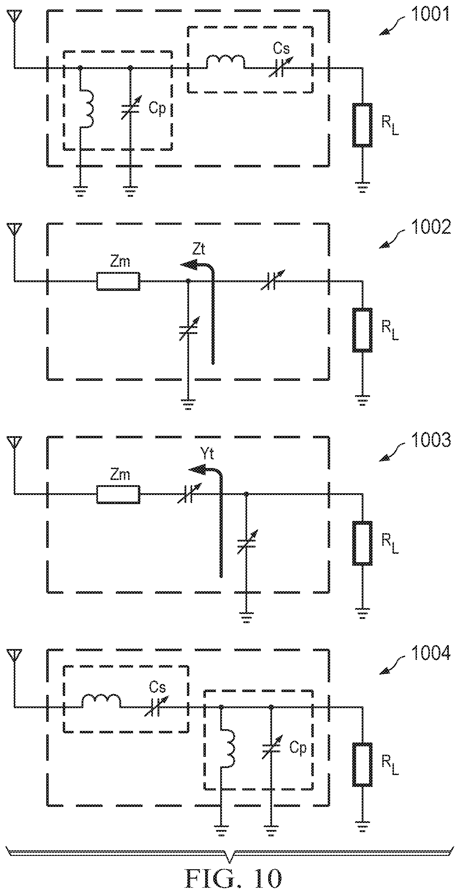

FIG. 10 illustrates diagrams of embodiment tunable matching circuits 1001, 1002, 1003, and 1004. As shown, the embodiment tunable matching circuits 1001, 1004 include a tunable capacitor (Cₛ) coupled in series with an inductor and an antenna, and a tunable capacitor (Cₚ) coupled in parallel with an inductor and the antenna. The embodiment tunable matching circuits 1002, 1003 includes a tunable capacitor coupled in series with an antenna, and a tunable capacitor coupled in parallel with the antenna.

The following provides an embodiment scheme for open loop impedance tuning using the tunable matching circuit 1001: 1. Measure the current return loss |Γ₀|; 2. Change the tunable shunt capacitor Cₛ value by ΔCₛ; 3. Measure the return loss |Γ₁ₛ|, restore original Cₛ; 4. Calculate |Γ₁ₛ| - |Γ₀|; 5. Change the tunable serial capacitor Cₛ value by ΔCₛ; 6. Measure the return loss |Γ₁ₚ|, restore original Cₚ; 7. Calculate |Γ₁ₚ| - |Γ₀|; 8. A table is created by using different phase angles of reflection coefficient and simulating the changing of capacitance of serial and shunt capacitance; 9. Search the table to find the matched reflection coefficient angle ψ; 10. Γ_{M} = |Γ₀|^{∗}exp(j^{∗} ψ);

Table 1 is a table of an embodiment look-up table to be used for closed loop impedance tuning. The following provides an embodiment scheme for closed loop impedance tuning using the tunable matching circuit 1001: 1. Measure the reflection coefficient Γ_{M}; 2. Calculate the antenna impedance with the knowledge of the configuration of tunable matching network; 3. Find the use case by searching the measured antenna impedance through table; 4. Get the tunable matching network configuration from look-up table and set the tunable matching network; 5. Monitor the measured reflection coefficient by changing Cₚ and Cₛ one steps, and compare with the target reflection coefficient; 6. Search for the optimum reflection coefficient setting by varying Cₛ and Cₚ.

**Table 1**

| State Number | Antenna Impedance | Tunable Capacitor Configuration | Target Reflection Coefficient |
|---|---|---|---|
| 1 | Z₁ | Configuration-1 | Γ₁ |
| 2 | Z₂ | Configuration-2 | Γ₂ |
| 3 | Z₃ | Configuration-3 | Γ₃ |
| ... | ... | ... | |
| N-1 | Z_{(N-1)} | Configuration-(N-1) | Γ_{N-1} |
| N | Z_{N} | Configuration-N | Γ_{N} |

The following provides an embodiment scheme for open-loop impedance tuning using the tunable matching circuit 1002: 1.Measure the current return loss |Γ₀|; 2. Change the tunable shunt capacitor Cₚ value by ΔCₚ; 3.Measure the return loss |Γ₁ₚ|, restore original Cₚ; 4. Calculate |Γ₁ₚ| - |Γ₀|; 5. Change the tunable serial capacitor Cₛ value by ΔCₛ; 6. Measure the return loss |Γ₁ₛ|, restore original Cₛ; 7. Calculate |Γ₁ₛ| - |Γ₀|; 8. A table is created by using different phase angles of reflection coefficient and simulating the changing of capacitance of serial and shunt capacitance; 9. Search the table to find the matched reflection coefficient angle; 10. Γ_{M} = |Γ₀|^{∗}exp(j^{∗} ψ).

Table 2 is a table of an embodiment look-up table to be used for closed loop impedance tuning. The following provides an embodiment scheme for closed loop impedance tuning using the tunable matching circuit 1001: 1. Measure the reflection coefficient Γ_{M}; 2. Calculate the antenna impedance with the knowledge of the configuration of tunable matching network; 3. Find the use case by searching the measured antenna impedance through table; 4. Get the tunable matching network configuration from look-up table and set the tunable matching network; 5. Monitor the measured reflection coefficient by changing Cₚ and Cₛ one steps, and compare with the target reflection coefficient; 6. Search for the optimum reflection coefficient setting by varying Cₛ and Cₚ.

**Table 2**

| State Number | Antenna Impedance | Tunable Capacitor Configuration |
|---|---|---|
| 1 | Z₁ | Configuration-1 |
| 2 | Z₂ | Configuration-2 |
| 3 | Z₃ | Configuration-3 |
| ... | ... | ... |
| N-1 | Z_{(N-1)} | Configuration-(N-1) |
| N | Z_{N} | Configuration-N |

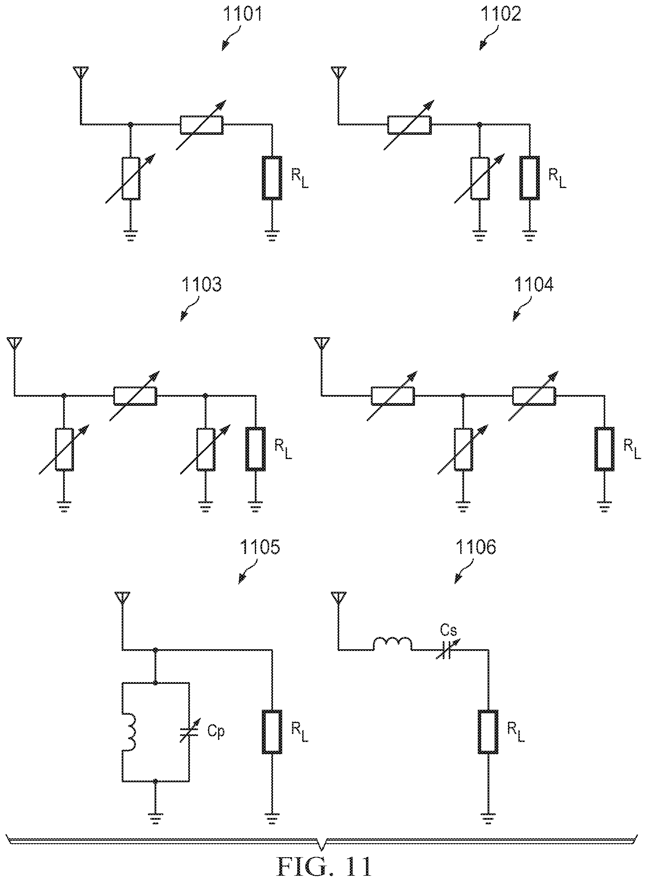

FIG. 11 illustrates diagrams of yet additional embodiment tunable matching circuits 1101, 1102, 1103, 1104, 1105, and 1106. As shown, the embodiment tunable matching circuits 1101, 1102 include a tunable element coupled in series with an antenna, and a tunable element coupled in parallel with the antenna. The embodiment tunable matching circuits 1103, 1104 include a tunable element coupled in series with an antenna, and two tunable elements coupled in parallel with the antenna. The embodiment tunable matching circuit 1105 includes a tunable capacitor coupled in parallel with an antenna. The embodiment tunable matching circuit 1106 includes a tunable capacitor coupled in series with an antenna.

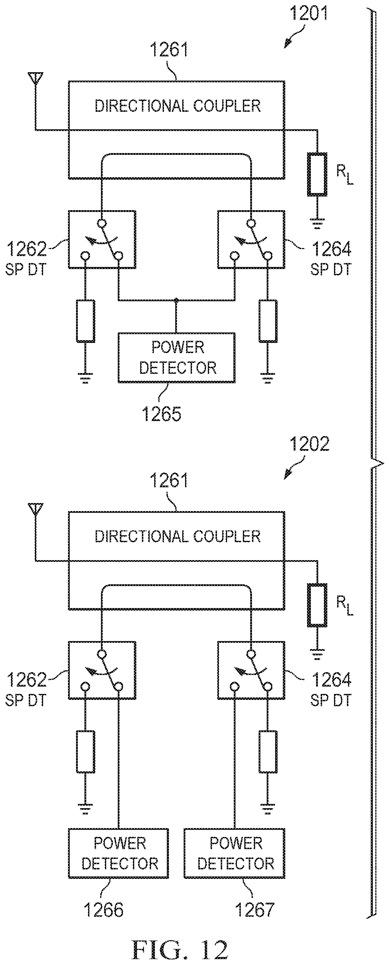

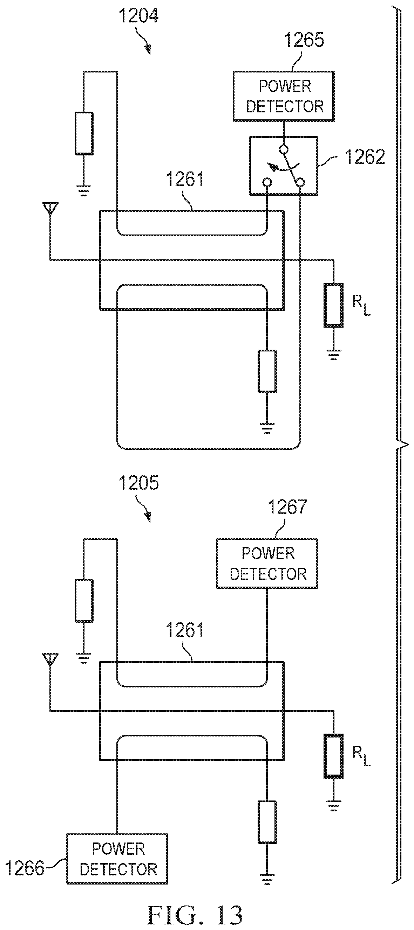

FIG. 12 illustrates diagrams of embodiment power detection circuits 1201, 1202. As shown, the power detection circuit 1201 includes a directional coupler 1261, switches 1264, and a power detector 1265. The directional coupler 1261 is coupled in series with an antenna. The directional coupler 1261 has input and transmit ports connected to the antenna and source(Rs), and coupled ports connected to the switches 1262, 1264. Depending on the configuration of the switches 1262, 1264, the power detector 1265 is configured to measure a power (e.g., voltage) of the incident and reflected signals. The power detection circuit 1202 is similar to the power detection circuit 1201, except that separate power detectors 1266, 1267 are used to measure the power of the incident and reflected signals (respectively). FIG. 13 illustrates diagrams of embodiment power detection circuits 1204, 1205. The embodiment power detection circuits 1204, 1205 include similar components as the power detection circuits 1201, 1202, that are arranged in a different configuration. Instead of one coupling path in 1201 and 1202, two coupling path are used here. In some examples, the switches 1262, 1264 are coupled to 50 ohm loads. The return loss may be computed as forward power divided by revers power. Although the switches 1262, 1264 are depicted as having a single pole double throw (SPDT) switching configuration, those of ordinary skill in the art will appreciate that other switching configuration are also possible.

Embodiments of this disclosure provide methods to determine the impedance (e.g., reflection coefficient) with a reverse and forward power ratio by adjusting a tunable capacitor and using the return loss variation. Embodiment systems are provided to adjust a tunable matching network to a target impedance goal. Such systems may include a directional coupler, a power detector for reverse and forward path, and a tunable matching network including at least one tunable component. The tunable matching network can be adjusted according to an open loop or closed loop scheme. When using an open loop scheme, the detected reflection coefficient is used to determine an index associated with an entry in an open loop look-up table. The index is used to provide information for adjusting an impedance matching element coupled to the antenna. When using a closed loop scheme, the measured detected reflection coefficient is used to determine an index associated with an entry in a look-up table for initial tunable matching network configuration and a target complex reflection coefficient. The controller may monitor the reflection coefficient and use it as the target for a searching algorithm to achieve the targeted complex reflection coefficient.

Regarding the effect of varying a tunable element. Given the measured reflection coefficient, a tunable element can be adjusted to obtain a different reflection coefficient. The phase angle can then be obtained by comparing the delta of return loss (e.g., the absolute value of reflection coefficient).

Embodiments of this disclosure may provide a cost effective way to implement closed loop antenna tuning, lower Bill of Material (BOM) cost, allow the application processor/modem processor to be reused as the closed loop controller, reuse the power detection circuit, enhanced use experience, fast convergence with open loop lookup table, closed loop tuning can be optimized for transmitting or receiving or any tradeoff between TX and RX.

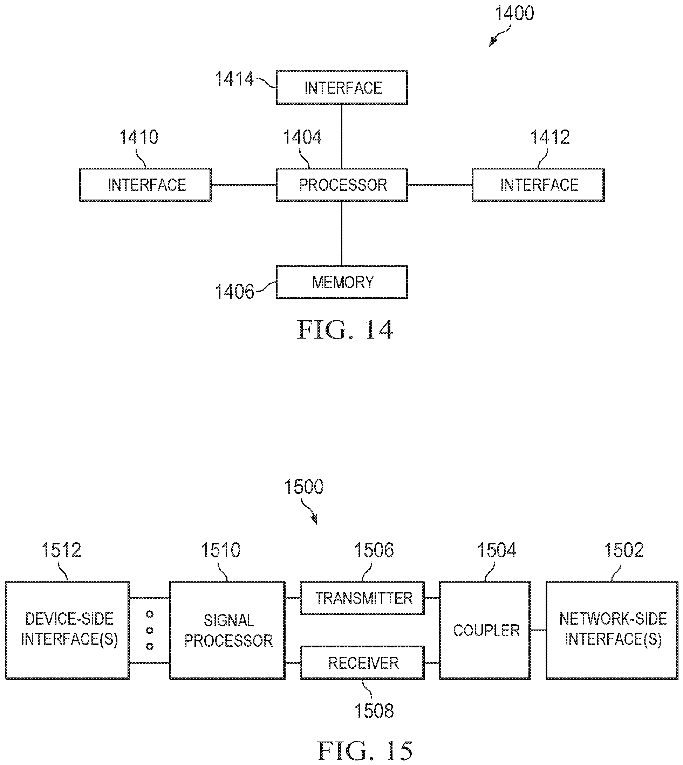

FIG. 14 illustrates a block diagram of an embodiment processing system 1400 for performing methods described herein, which may be installed in a host device. As shown, the processing system 1400 includes a processor 1404, a memory 1406, and interfaces 1410-1414, which may (or may not) be arranged as shown in FIG. 14. The processor 1404 may be any component or collection of components adapted to perform computations and/or other processing related tasks, and the memory 1406 may be any component or collection of components adapted to store programming and/or instructions for execution by the processor 1404. In an embodiment, the memory 1406 includes a non-transitory computer readable medium. The interfaces 1410, 1412, 1414 may be any component or collection of components that allow the processing system 1400 to communicate with other devices/components and/or a user. For example, one or more of the interfaces 1410, 1412, 1414 may be adapted to communicate data, control, or management messages from the processor 1404 to applications installed on the host device and/or a remote device. As another example, one or more of the interfaces 1410, 1412, 1414 may be adapted to allow a user or user device (e.g., personal computer (PC), etc.) to interact/communicate with the processing system 1400. The processing system 1400 may include additional components not depicted in FIG. 14, such as long term storage (e.g., non-volatile memory, etc.).

In some embodiments, the processing system 1400 is included in a network device that is accessing, or part otherwise of, a telecommunications network. In one example, the processing system 1400 is in a network-side device in a wireless or wireline telecommunications network, such as a base station, a relay station, a scheduler, a controller, a gateway, a router, an applications server, or any other device in the telecommunications network. In other embodiments, the processing system 1400 is in a user-side device accessing a wireless or wireline telecommunications network, such as a mobile station, a user equipment (UE), a personal computer (PC), a tablet, a wearable communications device (e.g., a smartwatch, etc.), or any other device adapted to access a telecommunications network.

In some embodiments, one or more of the interfaces 1410, 1412, 1414 connects the processing system 1400 to a transceiver adapted to transmit and receive signaling over the telecommunications network. FIG. 15 illustrates a block diagram of a transceiver 1500 adapted to transmit and receive signaling over a telecommunications network. The transceiver 1500 may be installed in a host device. As shown, the transceiver 1500 comprises a network-side interface 1502, a coupler 1504, a transmitter 1506, a receiver 1508, a signal processor 1510, and a device-side interface 1512. The network-side interface 1502 may include any component or collection of components adapted to transmit or receive signaling over a wireless or wireline telecommunications network. The coupler 1504 may include any component or collection of components adapted to facilitate bi-directional communication over the network-side interface 1502. The transmitter 1506 may include any component or collection of components (e.g., up-converter, power amplifier, etc.) adapted to convert a baseband signal into a modulated carrier signal suitable for transmission over the network-side interface 1502. The receiver 1508 may include any component or collection of components (e.g., down-converter, low noise amplifier, etc.) adapted to convert a carrier signal received over the network-side interface 1502 into a baseband signal. The signal processor 1510 may include any component or collection of components adapted to convert a baseband signal into a data signal suitable for communication over the device-side interface(s) 1512, or vice-versa. The device-side interface(s) 1512 may include any component or collection of components adapted to communicate data-signals between the signal processor 1510 and components within the host device (e.g., the processing system 1400, local area network (LAN) ports, etc.).

The transceiver 1500 may transmit and receive signaling over any type of communications medium. In some embodiments, the transceiver 1500 transmits and receives signaling over a wireless medium. For example, the transceiver 1500 may be a wireless transceiver adapted to communicate in accordance with a wireless telecommunications protocol, such as a cellular protocol (e.g., long-term evolution (LTE), etc.), a wireless local area network (WLAN) protocol (e.g., Wi-Fi, etc.), or any other type of wireless protocol (e.g., Bluetooth, near field communication (NFC), etc.). In such embodiments, the network-side interface 1502 comprises one or more antenna/radiating elements. For example, the network-side interface 1502 may include a single antenna, multiple separate antennas, or a multi-antenna array configured for multi-layer communication, e.g., single input multiple output (SIMO), multiple input single output (MISO), multiple input multiple output (MIMO), etc. In other embodiments, the transceiver 1500 transmits and receives signaling over a wireline medium, e.g., twisted-pair cable, coaxial cable, optical fiber, etc. Specific processing systems and/or transceivers may utilize all of the components shown, or only a subset of the components, and levels of integration may vary from device to device.

## Claims

1. A method (900) for matching the impedance of an antenna, the method comprising:
measuring (910) an initial return loss of an antenna, the initial return loss corresponding to a magnitude of a reflection coefficient;
adjusting (920) an impedance of at least a first tunable element coupled to the antenna;
measuring (925) a first adjusted return loss of the antenna, the first adjusted return loss corresponding to a magnitude of a first reflection coefficient, after adjusting the impedance of the first tunable element coupled to the antenna;
**characterized by**
adjusting (930) an impedance of at least a second tunable element coupled to the antenna;
measuring (935) a second adjusted return loss of the antenna, the second adjusted return loss corresponding to a magnitude of a second reflection coefficient, after adjusting the impedance of the second tunable element coupled to the antenna;
estimating (940) a phase of the reflection coefficient based on the initial return loss, the first adjusted return loss, and the second adjusted return loss; and
adjusting (950) an impedance matching element coupled to the antenna based on the magnitude and the phase of the reflection coefficient.

2. The method of claim 1, wherein the phase of the reflection coefficient is estimated based on the initial return loss, the first adjusted return loss, and the second adjusted return loss without directly measuring the phase of the reflection coefficient.

3. The method of claim 1, wherein estimating the phase of the reflection coefficient comprises:
estimating the phase of the reflection coefficient based on a difference between the initial return loss and the first adjusted return loss.

4. The method of claim 1, wherein estimating the phase of the reflection coefficient comprises:
looking up the phase of the reflection coefficient in a lookup table based on an entry associated with the initial return loss and the first adjusted return loss.

5. The method of claim 1, wherein the first tunable element includes a tunable capacitor.

6. The method of claim 1, wherein the first tunable element includes a tunable inductor.

7. The method of any preceding claim, wherein estimating the phase of the reflection coefficient comprises:
determining differences between the initial return loss and the first adjusted return loss over a range of potential phases;
determining differences between the initial return loss and the second adjusted return loss over the range of potential phases; and
identifying the phase of the reflection coefficient as a phase, in the range of potential phases, in which a difference between the initial return loss and the first adjusted return loss is the same as, or within a threshold of, the difference between the initial return loss and the second adjusted return loss.

8. The method of any preceding claim, wherein estimating the phase of the reflection coefficient comprises:
looking up the phase of the reflection coefficient in a lookup table based on an entry associated with the initial return loss, the first adjusted return loss, and the second adjusted return loss.

9. A transceiver comprising:
an antenna (701) configured to emit a wireless signal;
a power detection circuit (760) coupled to an antenna path of the antenna, the power detection circuit configured to detect power levels of incident and reflected signals propagating over the antenna path;
at least first and second tunable elements (712, 714) coupled to the antenna path of the antenna;
a processor (790); and
a computer readable storage medium storing programming for execution by the processor, the programming including instructions to:
measure an initial return loss of the antenna (701), the initial return loss corresponding to a magnitude of a reflection coefficient;
adjust an impedance of at least the first tunable element (712, 714) coupled to the antenna; and
measure a first adjusted return loss of the antenna, the first adjusted return loss corresponding to a magnitude of a first reflection coefficient, after adjusting the impedance of the first tunable element coupled to the antenna (701); **characterized in that** the programming includes instructions to:
adjust an impedance of at least the second tunable element (714, 712) coupled to the antenna; and
measure a second adjusted return loss of the antenna, the second adjusted return loss corresponding to a magnitude of a second reflection coefficient, after adjusting the impedance of the second tunable element coupled to the antenna;
estimate a phase of the reflection coefficient based on the initial return loss, the first adjusted return loss, and the second adjusted return loss; and
adjust an impedance matching element coupled to the antenna based on the magnitude and the phase of the reflection coefficient.

10. The transceiver of claim 9, wherein the phase of the reflection coefficient is estimated based on the initial return loss, the first adjusted return loss, and the second adjusted return loss without directly measuring the phase of the reflection coefficient.

11. The transceiver of claim 10, wherein the instructions to estimate the phase of the reflection coefficient include instructions to:
estimate the phase of the reflection coefficient based on a difference between the initial return loss and the first adjusted return loss.

12. The transceiver of claim 10, wherein the instructions to estimate the phase of the reflection coefficient include instructions to:
look up the phase of the reflection coefficient in a lookup table based on an entry associated with the initial return loss and the first adjusted return loss.

13. The transceiver of claim 10, wherein the first tunable element includes a tunable capacitor.

14. The transceiver of claim 10, wherein the first tunable element includes a tunable inductor.

## Patentansprüche

1. Verfahren (900) zur Anpassung der Impedanz einer Antenne, wobei das Verfahren Folgendes umfasst:
Messen (910) einer anfänglichen Rückflussdämpfung einer Antenne, wobei die anfängliche Rückflussdämpfung einer Größe eines Reflexionskoeffizienten entspricht;
Einstellen (920) einer Impedanz von zumindest einem ersten abstimmbaren Element, das an die Antenne gekoppelt ist;
Messen (925) einer ersten eingestellten Rückflussdämpfung der Antenne, wobei die erste eingestellte Rückflussdämpfung einer Größe eines ersten Reflexionskoeffizienten entspricht, nach dem Einstellen der Impedanz des ersten abstimmbaren Elements, das an die Antenne gekoppelt ist;
**gekennzeichnet durch**
Einstellen (930) einer Impedanz von zumindest einem zweiten abstimmbaren Element, das an die Antenne gekoppelt ist;
Messen (935) einer zweiten eingestellten Rückflussdämpfung der Antenne, wobei die zweite eingestellte Rückflussdämpfung einer Größe eines zweiten Reflexionskoeffizienten entspricht, nach dem Einstellen der Impedanz des zweiten abstimmbaren Elements, das an die Antenne gekoppelt ist;
Schätzen (940) einer Phase des Reflexionskoeffizienten basierend auf der anfänglichen Rückflussdämpfung, der ersten eingestellten Rückflussdämpfung und der zweiten eingestellten Rückflussdämpfung; und
Einstellen (950) eines Impedanzanpassungselements, das an die Antenne gekoppelt ist, basierend auf der Größe und der Phase des Reflexionskoeffizienten.

2. Verfahren nach Anspruch 1, wobei die Phase des Reflexionskoeffizienten basierend auf der anfänglichen Rückflussdämpfung, der ersten eingestellten Rückflussdämpfung und der zweiten eingestellten Rückflussdämpfung geschätzt wird, ohne die Phase des Reflexionskoeffizienten direkt zu messen.

3. Verfahren nach Anspruch 1, wobei das Schätzen der Phase des Reflexionskoeffizienten Folgendes umfasst:
Schätzen der Phase des Reflexionskoeffizienten basierend auf einem Unterschied zwischen der anfänglichen Rückflussdämpfung und der ersten eingestellten Rückflussdämpfung.

4. Verfahren nach Anspruch 1, wobei das Schätzen der Phase des Reflexionskoeffizienten Folgendes umfasst:
Nachschlagen der Phase des Reflexionskoeffizienten in einer Lookup-Tabelle basierend auf einem Eintrag in Verbindung mit der anfänglichen Rückflussdämpfung und der ersten eingestellten Rückflussdämpfung.

5. Verfahren nach Anspruch 1, wobei das erste abstimmbare Element einen abstimmbaren Kondensator beinhaltet.

6. Verfahren nach Anspruch 1, wobei das erste abstimmbare Element einen abstimmbaren Induktor beinhaltet.

7. Verfahren nach einem vorhergehenden Anspruch, wobei das Schätzen der Phase des Reflexionskoeffizienten Folgendes umfasst:
Bestimmen von Unterschieden zwischen der anfänglichen Rückflussdämpfung und der ersten eingestellten Rückflussdämpfung über eine Reihe an potentiellen Phasen;
Bestimmen von Unterschieden zwischen der anfänglichen Rückflussdämpfung und der zweiten eingestellten Rückflussdämpfung über die Reihe an potentiellen Phasen; und
Identifizieren der Phase des Reflexionskoeffizienten als eine Phase, in der Reihe an potentiellen Phasen, in der ein Unterschied zwischen der anfänglichen Rückflussdämpfung und der ersten eingestellten Rückflussdämpfung der gleiche ist wie der Unterschied zwischen der anfänglichen Rückflussdämpfung und der zweiten eingestellten Rückflussdämpfung oder sich innerhalb eines Schwellenwertes davon befindet.

8. Verfahren nach einem vorhergehenden Anspruch, wobei das Schätzen der Phase des Reflexionskoeffizienten Folgendes umfasst:
Nachschlagen der Phase des Reflexionskoeffizienten in einer Lookup-Tabelle basierend auf einem Eintrag in Verbindung mit der anfänglichen Rückflussdämpfung, der ersten eingestellten Rückflussdämpfung und der zweiten eingestellten Rückflussdämpfung.

9. Sendeempfänger, umfassend:
eine Antenne (701), die konfiguriert ist, um ein Drahtlossignal zu emittieren;
eine Leistungserfassungsschaltung (760), die an einen Antennenweg der Antenne gekoppelt ist, wobei die Leistungserfassungsschaltung konfiguriert ist, um Leistungsniveaus von einfallenden und reflektierten Signalen zu erfassen, die über den Antennenweg propagieren;
zumindest ein erstes und ein zweites abstimmbares Element (712, 714), die an den Antennenweg der Antenne gekoppelt sind;
einen Prozessor (790); und
ein computerlesbares Speichermedium, das Programmierung zur Ausführung durch den Prozessor speichert, wobei die Programmierung Anweisungen für Folgendes beinhaltet:
Messen einer anfänglichen Rückflussdämpfung der Antenne (701),
wobei die anfängliche Rückflussdämpfung einer Größe eines Reflexionskoeffizienten entspricht;
Einstellen einer Impedanz von zumindest dem ersten abstimmbaren Element (712, 714), das an die Antenne gekoppelt ist; und Messen einer ersten eingestellten Rückflussdämpfung der Antenne,
wobei die erste eingestellte Rückflussdämpfung einer Größe eines ersten Reflexionskoeffizienten entspricht, nach dem Einstellen der Impedanz des ersten abstimmbaren Elements, das an die Antenne (701) gekoppelt ist;
**dadurch gekennzeichnet, dass** das Programmieren Anweisungen für Folgendes beinhaltet:
Einstellen einer Impedanz von zumindest dem zweiten abstimmbaren Element (714, 712), das an die Antenne gekoppelt ist; und
Messen einer zweiten eingestellten Rückflussdämpfung der Antenne, wobei die zweite eingestellte Rückflussdämpfung einer Größe eines zweiten Reflexionskoeffizienten entspricht, nach dem Einstellen der Impedanz des zweiten abstimmbaren Elements, das an die Antenne gekoppelt ist;
Schätzen einer Phase des Reflexionskoeffizienten basierend auf der anfänglichen Rückflussdämpfung, der ersten eingestellten Rückflussdämpfung und der zweiten eingestellten Rückflussdämpfung; und
Einstellen eines Impedanzanpassungselements, das an die Antenne gekoppelt ist, basierend auf der Größe und der Phase des Reflexionskoeffizienten.

10. Sendeempfänger nach Anspruch 9, wobei die Phase des Reflexionskoeffizienten basierend auf der anfänglichen Rückflussdämpfung, der ersten eingestellten Rückflussdämpfung und der zweiten eingestellten Rückflussdämpfung geschätzt wird, ohne die Phase des Reflexionskoeffizienten direkt zu messen.

11. Sendeempfänger nach Anspruch 10, wobei die Anweisungen zum Schätzen der Phase des Reflexionskoeffizienten Anweisungen für Folgendes beinhalten:
Schätzen der Phase des Reflexionskoeffizienten basierend auf einem Unterschied zwischen der anfänglichen Rückflussdämpfung und der ersten eingestellten Rückflussdämpfung.

12. Sendeempfänger nach Anspruch 10, wobei die Anweisungen zum Schätzen der Phase des Reflexionskoeffizienten Anweisungen für Folgendes beinhalten:
Nachschlagen der Phase des Reflexionskoeffizienten in einer Lookup-Tabelle basierend auf einem Eintrag in Verbindung mit der anfänglichen Rückflussdämpfung und der ersten eingestellten Rückflussdämpfung.

13. Sendeempfänger nach Anspruch 10, wobei das erste abstimmbare Element einen abstimmbaren Kondensator beinhaltet.

14. Sendeempfänger nach Anspruch 10, wobei das erste abstimmbare Element einen abstimmbaren Induktor beinhaltet.

## Revendications

1. Procédé (900) pour adapter l'impédance d'une antenne, le procédé comprenant :
la mesure (910) d'un affaiblissement de réflexion initial d'une antenne, l'affaiblissement de réflexion initial correspondant à une amplitude d'un coefficient de réflexion ;
l'ajustement (920) d'une impédance d'au moins un premier élément accordable couplé à l'antenne ;
la mesure (925) d'un premier affaiblissement de réflexion initial de l'antenne, le premier affaiblissement de réflexion initial ajusté correspondant à une amplitude d'un premier coefficient de réflexion, après l'ajustement de l'impédance du premier élément accordable couplé à l'antenne ;
**caractérisé par** l'ajustement (930) d'une impédance d'au moins un deuxième élément accordable couplé à l'antenne ;
la mesure (935) d'un second affaiblissement de réflexion ajusté de l'antenne, le second affaiblissement de réflexion ajusté correspondant à une amplitude d'un second coefficient de réflexion, après l'ajustement de l'impédance du second élément accordable couplé à l'antenne ;
l'estimation (940) d'une phase du coefficient de réflexion sur la base de l'affaiblissement de réflexion initial, du premier affaiblissement de réflexion ajusté et du second affaiblissement de réflexion ajusté ; et
l'ajustement (950) d'une impédance correspondant à l'élément couplé à l'antenne en se basant sur l'amplitude et la phase du coefficient de réflexion.

2. Procédé selon la revendication 1, dans lequel la phase du coefficient de réflexion est estimée en se basant sur l'affaiblissement de réflexion initial, le premier affaiblissement de réflexion ajusté et le second affaiblissement de réflexion ajusté sans mesurer directement la phase du coefficient de réflexion.

3. Procédé selon la revendication 1, dans lequel l'estimation de la phase du coefficient de réflexion comprend :
l'estimation de la phase du coefficient de réflexion en se basant sur une différence entre l'affaiblissement de réflexion initial et le premier affaiblissement de réflexion ajusté.

4. Procédé selon la revendication 1, dans lequel l'estimation de la phase du coefficient de réflexion comprend :
la consultation de la phase du coefficient de réflexion dans une table de consultation en se basant sur une entrée associée à l'affaiblissement de réflexion initial et au premier affaiblissement de réflexion ajusté.

5. Procédé selon la revendication 1, dans lequel le premier élément accordable inclut un condensateur accordable.

6. Procédé selon la revendication 1, dans lequel le premier élément accordable inclut un inducteur accordable.

7. Procédé selon une quelconque revendication précédente, dans lequel l'estimation de la phase du coefficient de réflexion comprend :
la détermination de différences entre l'affaiblissement de réflexion initial et le premier affaiblissement de réflexion ajusté sur une plage de phases potentielles ;
la détermination de différences entre l'affaiblissement de réflexion initial et le second affaiblissement de réflexion ajusté sur une plage de phases potentielles ; et
l'identification de la phase du coefficient de réflexion en tant que phase, dans la plage de phases potentielles, dans laquelle une différence entre l'affaiblissement de réflexion initial et le premier affaiblissement de réflexion ajusté est la même que, ou au sein d'un seuil de, la différence entre l'affaiblissement de réflexion initial et le second affaiblissement de réflexion ajusté.

8. Procédé selon une quelconque revendication précédente, dans lequel l'estimation de la phase du coefficient de réflexion comprend :
la consultation de la phase du coefficient de réflexion dans une table de consultation en se basant sur une entrée associée à l'affaiblissement de réflexion initial, au premier affaiblissement de réflexion ajusté et au second affaiblissement de réflexion ajusté.

9. Emetteur-récepteur comprenant :
une antenne (701) configurée pour émettre un signal sans fil ;
un circuit de détection de puissance (760) couplé à un chemin d'antenne de l'antenne, le circuit de détection de puissance étant configuré pour détecter des niveaux de puissance de signaux incidents et réfléchis se propageant sur le chemin d'antenne ;
au moins des premier et second éléments accordables (712, 714) couplés au chemin d'antenne de l'antenne ;
un processeur (790) ; et
un support de stockage lisible sur un ordinateur stockant un programme pour une exécution par le processeur, le programme incluant des instructions pour :
mesurer un affaiblissement de réflexion initial de l'antenne (701), l'affaiblissement de réflexion initial correspondant à une amplitude d'un coefficient de réflexion ;
ajuster une impédance d'au moins le premier élément accordable (712, 714) couplé à l'antenne ; et
mesurer un premier affaiblissement de réflexion ajusté de l'antenne, le premier affaiblissement de réflexion ajusté correspondant à une amplitude d'un premier coefficient de réflexion, après l'ajustement de l'impédance du premier élément accordable couplé à l'antenne (701) ;
**caractérisé en ce que** le programme inclut des instructions pour :
ajuster une impédance d'au moins le second élément accordable (714, 712) couplé à l'antenne ; et
mesurer un second affaiblissement de réflexion ajusté de l'antenne, le second affaiblissement de réflexion ajusté correspondant à une amplitude d'un second coefficient de réflexion, après l'ajustement de l'impédance du second élément accordable couplé à l'antenne ;
estimer une phase du coefficient de réflexion en se basant sur l'affaiblissement de réflexion initial, le premier affaiblissement de réflexion ajusté et le second affaiblissement de réflexion ajusté ; et
ajuster une un élément s'adaptant à l'impédance couplé à l'antenne en se basant sur l'amplitude et la phase du coefficient de réflexion.

10. Emetteur-récepteur selon la revendication 9, dans lequel la phase du coefficient de réflexion est estimée en se basant sur l'affaiblissement de réflexion initial, le premier affaiblissement de réflexion ajusté et le second affaiblissement de réflexion ajusté sans mesurer directement la phase du coefficient de réflexion.

11. Emetteur-récepteur selon la revendication 10, dans lequel les instructions pour estimer la phase du coefficient de réflexion incluent des instructions pour :
estimer la phase du coefficient de réflexion en se basant sur une différence entre l'affaiblissement de réflexion initial et le premier affaiblissement de réflexion ajusté.

12. Emetteur-récepteur selon la revendication 10, dans lequel les instructions pour estimer la phase du coefficient de réflexion incluent des instructions pour :
consulter la phase du coefficient de réflexion dans une table de consultation en se basant sur une entrée associée à l'affaiblissement de réflexion initial et au premier affaiblissement de réflexion ajusté.

13. Emetteur-récepteur selon la revendication 10, dans lequel le premier élément accordable inclut un condensateur accordable.

14. Emetteur-récepteur selon la revendication 10, dans lequel le premier élément accordable inclut un inducteur accordable.
